# FASCICULE DE BREVET EUROPEEN

(11) **EP 1 459 602 B1**
(45) Date de publication et mention de la délivrance du brevet: **08.05.2019**
(21) Numéro de dépôt: 02805796.6
(22) Date de dépôt: 12.12.2002
(51) Int. Cl.: H01L 51/00

(54) **VITRE FEUILLETEE AVEC UN ELEMENT FONCTIONNEL A COMMANDE ELECTRIQUE**
LAMINIERTE GLASSCHEIBE MIT ELEKTRISCH GESTEUERTEM FUNKTIONALELEMENT
LAMINATED GLASS PLANE WITH ELECTRICALLY CONTROLLED FUNCTIONAL ELEMENT

(30) Priorité: 24.12.2001 DE 10164063
(43) Date de publication de la demande: 22.09.2004
(73) Titulaire: SAINT-GOBAIN GLASS FRANCE, 92400 Courbevoie (FR)
(72) Inventeur: MAEUSER, Helmut, 52134 Herzogenrath (DE)
(74) Mandataire: Saint-Gobain Recherche
(86) Numéro de dépôt international: PCT/FR2002/004326
(87) Numéro de publication internationale: WO 2003/056880

(56) Documents cités:
- EP-A- 0 267 331
- EP-A- 1 083 613
- PATENT ABSTRACTS OF JAPAN vol. 013, no. 564 (E-860), 14 décembre 1989 (1989-12-14) & JP 01 235190 A (YOKOGAWA ELECTRIC CORP), 20 septembre 1989 (1989-09-20)
- PATENT ABSTRACTS OF JAPAN vol. 013, no. 481 (E-838), 31 octobre 1989 (1989-10-31) & JP 01 189889 A (OKI ELECTRIC IND CO LTD), 31 juillet 1989 (1989-07-31)
- LACHINOV A ET AL: "New Effects In Electroactive Polymers - New Basic For Sensors" TRANSDUCERS 95 . EUROSENSORS IX, vol. 2, 25 juin 1995 (1995-06-25), pages 198-201, XP010305123

## Description

L'invention se rapporte à une vitre feuilletée comportant au moins une vitre rigide et un élément fonctionnel plat à commande électrique tel qu'un élément lumineux électroluminescent, ainsi qu'au moins une mince couche électriquement conductrice.

Par vitre feuilletée, on entend ici une unité constituée d'une vitre rigide et de l'élément fonctionnel composé lui-même de plusieurs couches et assemblé à la vitre rigide, respectivement appliqué sur celle-ci. Comme éléments fonctionnels au sens de la présente description, on entend des éléments plats comme des éléments lumineux électroluminescents ou aussi des éléments de vitre avec une transmission de la lumière à commande électrique, par exemple des éléments du type cristaux liquides. Il existe donc des propriétés optiques de l'élément fonctionnel respectif, qui peuvent être commandées électriquement.

Il n'est pas absolument nécessaire de placer l'élément fonctionnel entre deux vitres rigides d'une vitre feuilletée, mais on préférera cette disposition pour des raisons de sécurité, eu égard à une tension d'alimentation éventuellement assez élevée (pour des éléments lumineux électroluminescents). Le placement dans une vitre feuilletée protège en outre l'élément fonctionnel contre des actions mécaniques ainsi que contre la pénétration d'humidité et de saletés.

La matière des vitres rigides elles-mêmes peut en principe être choisie librement; on peut de la même manière utiliser des vitres de plastique ou des vitres de verre. Il est bien connu également que l'on peut fabriquer industriellement des feuilletés mixtes en vitres de verre et de plastique.

Par le document EP-A1-0 267 331, on connaît une vitre feuilletée pour des véhicules avec un signe placé dans la couche adhésive du feuilleté, qui est représenté ou qui peut être illuminé par l'arrière par un élément lumineux électroluminescent ("EL"). Les conducteurs électriques nécessaires sont représentés de façon pratiquement invisible par des pistes ou des couches conductrices transparentes à l'intérieur du feuilleté. Après application de la tension d'alimentation, le signal lumineux semble flotter dans la vitre sans conducteurs visibles. Le document précité présente deux types différents d'éléments lumineux. Dans le premier, il est prévu deux électrodes conductrices sur le même substrat, qui sont recouvertes par l'élément lumineux, qui comprend à son tour une électrode de jonction. D'un point de vue électrique, il s'est ainsi formé deux capacités montées en série. Dans le second type, une des deux électrodes est respectivement déposée sous forme d'une couche mince transparente sur les deux surfaces intérieures de la vitre feuilletée et l'élément lumineux est disposé entre elles. On y décrit aussi, à titre d'option, que la sortie de lumière à travers une des vitres peut être empêchée au moyen d'un revêtement opaque.

Dans la demande de brevet allemand ancienne 101 26 868.6, on décrit une vitre avec un revêtement opaque tramé, dans laquelle il est prévu, au moins dans une partie des portions de surface opaques, au moins un élément lumineux EL plat à plusieurs couches avec une électrode transparente, lequel, après l'application d'une tension électrique, émet de la lumière sur le côté de l'électrode transparente d'une des faces plates de la vitre. Une vitre feuilletée de ce type peut être utilisée par exemple comme vitre de toit dans un véhicule, qui éclaire l'habitacle dans l'obscurité par un éclairage intérieur en surface.

Pour la plupart des domaines d'utilisation des vitres feuilletées, on désire une teinte lumineuse pratiquement constante de l'élément lumineux EL. Dans le fonctionnement de tels éléments lumineux EL en couche épaisse inorganique de grande étendue, surtout dans les véhicules automobiles, il apparaît cependant que des différences dans la couleur émise peuvent se manifester lors de variations de la température. Ainsi, un élément lumineux EL luira à - 20°C avec une tout autre couleur qu'à + 80°C, ces valeurs de température étant pourtant réalistes en cours d'utilisation d'un véhicule automobile. Une teinte lumineuse déterminée, dont la couleur s'harmonise par exemple avec son environnement de montage, ne peut être réglée que pour un certain domaine limité de température.

La littérature mentionnée plus haut n'aborde pas ce problème. Certes, ces éléments lumineux dégagent en fonctionnement une certaine chaleur propre à cause de la puissance dissipée; celle-ci est cependant négligeable en pratique.

Des essais menés en vue d'équilibrer la teinte lumineuse par une injection de la fréquence de la tension d'alimentation, conduisent à une réduction drastique de la durée de vie de l'élément lumineux EL.

On peut certes, à l'aide d'une sonde de température, empêcher complètement l'allumage de l'élément lumineux EL aux basses températures. On évite ainsi également des effets négatifs du fonctionnement à basse température sur la durée de vie de l'élément lumineux EL.

Les principes de base de l'électroluminescence sont connus depuis longtemps. Une documentation détaillée et les teintes lumineuses réalisables peuvent être obtenues à l'adresse internet "http://dupont.com/mcm/luxprint/about.html" (situation: décembre 2001), de sorte qu'il ne faut revenir que brièvement ici sur des détails.

On réalise un condensateur à partir de deux couches conductrices, dont au moins une est transparente / laisse passer la lumière. Sur l'électrode transparente, on dépose dans le condensateur une couche (opaque) avec des pigments lumineux et une couche isolante (diélectrique). Si l'on applique aux deux électrodes de cet élément une tension alternative (habituellement 100 V ∼) celle-ci induit dans les pigments des courants qui produisent à leur tour, par des processus de dispersion, de la lumière qui sort à travers l'électrode transparente.

Les couches d'électrode ainsi que la couche d'électroluminescence elle-même et la couche diélectrique peuvent être déposées par sérigraphie en couche épaisse sur des substrats appropriés comme le verre ou des films PET. On produit par cet effet connu des effets lumineux de surface, qui peuvent être utilisés à de multiples fins (éclairage, logos, signalisation lumineuse), si l'on accepte la densité lumineuse relativement faible et le choix de couleurs limité par les matériaux utilisables. En outre, les éléments électroluminescents eux-mêmes (dans la suite éléments lumineux) ne sont pas transparents, de sorte qu'une surface garnie de ceux-ci ne laisse pas passer de lumière (du jour).

On connaît en outre des éléments de vitre à commande électrique, qui travaillent sur la base de cristaux liquides et dont la transmission de la lumière peut être modifiée par l'application d'une tension. Ces éléments peuvent également présenter aux températures extrêmes des variations indésirables du degré de transmission instantané. Ainsi, un tel élément de vitre peut, à l'état éteint, où il devrait en fait rester opaque, devenir spontanément transparent à des températures inférieures à - 5°C.

On sait par de multiples descriptions que des couches minces d'oxydes dopées ou métalliques conductrices transparentes peuvent être utilisées comme chauffage de surface de vitres. Il est nécessaire à cet effet de conduire, par des alimentations ou des électrodes appropriées, un courant sur l'étendue de la couche, qui s'échauffe par suite de sa résistance ohmique. De telles couches constituent en règle générale une partie d'un système de couches composé de plusieurs couches minces, la plupart du temps transparent à la lumière visible, qui peut aussi présenter des propriétés d'isolation thermique ou de réflexion. Les couches minces sont des couches déposées par un procédé autre que la sérigraphie.

On connaît aussi des commandes agissant automatiquement avec des capteurs, avec lesquels une vitre (de véhicule) est chauffée automatiquement, par exemple pour éliminer la buée sur la face intérieure de cette vitre.

Le document JP01235190 propose un dispositif électroluminescent avec des moyens chauffants additionnels.

Le document JP01189889 propose également un dispositif électroluminescent avec des moyens chauffants additionnels.

L'invention a pour objet de réduire les variations dues à la température des propriétés d'un élément fonctionnel à commande électrique disposé sur ou dans une vitre feuilletée.

Conformément à l'invention, cet objectif est atteint par le fait que la couche forme en même temps une électrode plate de l'élément fonctionnel, cette couche pouvant être alimentée avec une tension électrique et chauffée indépendamment de l'alimentation électrique de l'élément fonctionnel.

L'invention a ainsi pour objet une vitre feuilletée comportant au moins une vitre rigide et un élément fonctionnel plat à commande électrique tel qu'un élément lumineux électroluminescent, ainsi qu'au moins une mince couche électriquement conductrice. L'élément fonctionnel plat est un élément lumineux électroluminescent et la couche forme en même temps une électrode plate de l'élément fonctionnel, la couche pouvant être alimentée avec une tension électrique et chauffée indépendamment de l'alimentation électrique de l'élément fonctionnel, la couche étant mise en liaison électriquement conductrice avec au moins deux pistes conductrices destinées à fournir une tension d'alimentation pour le chauffage, qui sont disposées de part et d'autre de l'élément fonctionnel recouvrant la couche.

Les caractéristiques des revendications secondaires présentent des perfectionnements avantageux de cet objet. La revendication indépendante 11 indique un procédé pour utiliser un élément fonctionnel associé à une vitre feuilletée.

Ainsi, l'élément fonctionnel est couplé à une couche chauffante en surface (couche de chauffage) qui permet, en tous cas aux basses températures ambiantes, d'augmenter la température de l'élément fonctionnel jusque dans le domaine pour lequel ses propriétés optiques, par exemple la teinte de la lumière émise, ont été conçues.

Dans une variante préférée, l'arrivée d'énergie, respectivement de courant à la couche de chauffage est commandée automatiquement à l'aide d'une sonde de température. Pour une valeur de mesure de la sonde de température inférieure à un seuil prédéterminé, le chauffage de l'élément fonctionnel est allumé jusqu'à ce que la température mesurée se situe dans le domaine désiré ou défini.

On peut travailler avec une mesure de la température ambiante ou extérieure, ou aussi utiliser la température intérieure de l'habitacle d'un véhicule comme grandeur de mesure. De manière préférée, on disposera cependant la sonde de température aussi près que possible de l'élément fonctionnel, par exemple en intégrant celle-ci dans la vitre feuilletée, afin d'obtenir une réponse aussi sensible que possible de la commande de température à la température effective de l'élément fonctionnel.

En principe, la vitre feuilletée peut être pourvue d'une couche de chauffage transparente séparée, qui n'est pas couplée de manière fonctionnelle à l'élément fonctionnel. D'une façon particulièrement avantageuse, on peut cependant aussi utiliser, pour le chauffage éventuel, une des couches d'électrode qu'il faut de toute façon prévoir pour l'élément fonctionnel. L'alimentation électrique de la fonction de chauffage peut être assurée avec une tension continue, qui est appliquée à deux électrodes de part et d'autre de l'élément fonctionnel. Pour un couplage uniforme du potentiel de tension dans l'électrode transparente (couche ITO), il faut de toute façon une piste conductrice large. Par conséquent, une seule électrode supplémentaire est nécessaire, dont la disposition doit être choisie en fonction de la tension de chauffage choisie. Pour obtenir une puissance de chauffage suffisante sous de basses tensions d'alimentation (par exemple 12 V en tension continue), la distance du busbar doit être faible, en tout cas inférieure à la largeur.

Le courant circulant entre les deux électrodes assure un chauffage de la couche et de l'élément fonctionnel assemblé en surface à celle-ci; il n'affecte cependant pas l'alimentation électrique (en tension alternative) de l'élément fonctionnel.

En principe, il importe peu en l'occurrence que l'élément fonctionnel soit déposé ou imprimé directement sur une face d'une vitre rigide ou qu'il soit fabriqué sur un substrat porteur particulier comme par exemple sur un film de PET, qui est ultérieurement assemblé de manière appropriée à la vitre rigide ou stratifié dans un composite. Dans les deux configurations, la couche de chauffage peut être disposée soit entre la vitre rigide ou le film porteur et l'élément fonctionnel soit sur le côté de l'élément fonctionnel situé à l'opposé de la vitre ou du film porteur.

Au-delà de l'influence positive sur les propriétés de l'élément fonctionnel, en particulier de la meilleure constance de la couleur d'un élément lumineux EL, cette couche de chauffage peut en outre augmenter le confort thermique dans un véhicule, précisément lorsque la vitre feuilletée est disposée dans la région du toit.

Le rapport entre la surface de l'élément fonctionnel et la surface totale de la vitre peut également être choisi librement. Au besoin, on peut disposer plusieurs éléments fonctionnels ou lumineux avec des couleurs et des formes éventuellement différentes, les uns à côté des autres.

Enfin, il peut également être intéressant, pour des cas d'application déterminés, d'émettre de la lumière à partir d'un ou de plusieurs éléments lumineux électroluminescents sur les deux faces planes de la vitre. On peut alors se passer d'un revêtement opaque séparé, parce que les couches électroluminescentes elles-mêmes ne laissent pas passer de lumière visible. En principe, on peut aussi "empiler" l'un sur l'autre plusieurs éléments lumineux électroluminescents de cette nature, éventuellement avec des orientations opposées l'une à l'autre, pour lesquels on peut éventuellement employer une électrode intermédiaire commune. Cette électrode intermédiaire peut à nouveau servir aussi de couche de chauffage, conformément à l'invention.

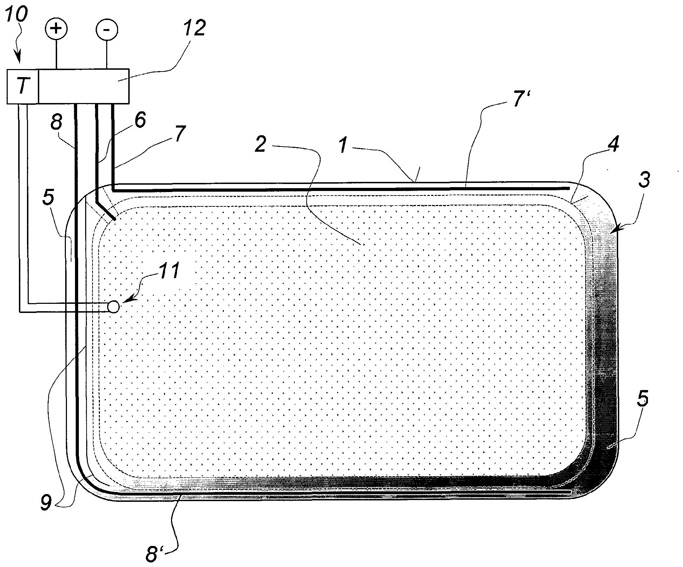

D'autres détails et avantages de l'objet de l'invention apparaîtront par le dessin d'un exemple de réalisation et de sa description détaillée qui suit. La description est présentée en faisant référence à un élément lumineux EL, sans vouloir toutefois exclure ainsi d'autres éléments fonctionnels de cette application.

La figure unique montre, dans une représentation simplifiée, et à titre d'exemple une vue d'une vitre avec un élément lumineux EL et un revêtement à chauffage électrique.

Une vitre rigide 1 porte un élément lumineux EL 2, qui s'étend presque sur toute la zone de la surface de la vitre 1, mais qui laisse libre une zone de bord périphérique 3 de la vitre. Une ligne en traits interrompus 4 désigne la limitation d'une bande de bord extérieure de la face de la vitre, qui peut être couverte par une couche colorée opaque, qui sert de protection visuelle. Naturellement, cette limitation peut aussi se trouver dans la zone de la surface de la vitre 1 recouverte par l'élément lumineux EL 2; elle n'est représentée ici à l'extérieur de cette zone de surface que pour des raisons de clarté.

Sous l'élément lumineux EL 2 est disposée une couche électriquement conductrice, de préférence transparente 5, qui s'étend sur toute la surface de la vitre 1 et aussi recouvre la bande de bord rendue opaque. On respectera aussi - de façon connue en soi - une distance de quelques millimètres entre cette couche 5 et le bord de la vitre, afin d'éviter la corrosion. La couche 5 est en règle générale une couche partielle d'un système de couches multiples, dont les propriétés de couleur et de réflexion sont réglables dans de larges limites en fonction des besoins par une définition ciblée des épaisseurs et des matières des couches individuelles. Pour la fonction décrite ici, ce n'est cependant essentiellement que la conductibilité électrique et l'aptitude au chauffage d'au moins une des couches individuelles qui sont importantes. La couche 5 peut se composer par exemple d'oxyde d'étain-indium (ITO), mais aussi d'un métal, par exemple d'argent.

Cette couche 5 forme une des électrodes plates de l'élément lumineux EL 2 construit au total comme un condensateur, de préférence l'électrode de masse. Si la lumière de celui-ci doit être émise à travers cette électrode, elle doit naturellement être transparente à la lumière visible. L'alimentation électrique (tension alternative) de l'autre côté de l'élément lumineux EL 2 est indiquée par un raccord 6, qui est isolé par rapport à la couche 5 et qui est raccordé d'une façon non représentée en détail à la seconde électrode plate de l'élément lumineux EL 2. Le raccord 6 est raccordé d'une façon non représentée à une autre électrode plate sur le côté, situé ici en haut, de l'élément lumineux EL 2.

Deux autres raccords 7 et 8 servent à acheminer une tension d'alimentation (tension continue) à la couche 5. Tous les raccords sont disposés dans une zone d'angle de la vitre 1. Les raccords 7 et 8 sont en liaison électrique avec des pistes conductrices 7' et 8'. La piste conductrice 7' s'étend à partir de l'angle de la vitre le long du long côté latéral supérieur (dans la représentation) de la vitre jusqu'à proximité de l'angle suivant de la vitre. La piste conductrice 8' s'étend d'abord le long d'un court côté latéral de la vitre 1, décrit un arc serré le long de l'angle de la vitre et s'étend alors le long du long côté latéral inférieur de la vitre jusqu'à proximité de l'angle suivant.

Les pistes conductrices 7' et 8' (dans les chauffages conventionnels des vitres, on les appelle aussi des rails collecteurs) peuvent être réalisées sous la forme de minces bandes de film métallique, qui sont fixées de manière adéquate sur la vitre. On peut cependant aussi les appliquer sur une vitre rigide par sérigraphie d'une pâte d'impression conductrice et ensuite les cuire - par exemple lors du cintrage et/ou de la trempe d'une vitre de verre. En tout cas, elles sont raccordées électriquement sur une grande surface à la couche électriquement conductrice 5, et elles peuvent se trouver au-dessus ou en dessous de la couche 5. Au besoin, la couche pourrait même être enfermée entre deux pistes conductrices déposées l'une après l'autre (une avant l'application de la couche, et une après). En outre, les pistes conductrices 7' et 8' sont disposées de telle manière qu'elles enferment entre elles la surface de la couche 5 recouverte par l'élément lumineux EL 2. De même, elles sont posées de façon masquée à la vue dans la zone de bord rendue opaque de la vitre 1. Naturellement, il peut aussi être prévu un autre masque visuel de l'autre côté de la vitre visible ici.

A l'aide d'une ligne de séparation 9 tracée dans la couche 5 parallèlement au côté latéral court, la piste conductrice 8' est séparée du reste du champ de la couche avec une haute résistance ohmique. Cette mesure est nécessaire, parce que ou lorsque les deux raccords 7 et 8 sont situés relativement près l'un à côté de l'autre. Certes, leur mise en contact électrique vers l'extérieur est ainsi simplifiée (par exemple on peut utiliser un assemblage commun à plusieurs broches ou par brasage), toutefois, sans la ligne de séparation 9, le courant de chauffage circulerait sur le chemin le plus court, donc pratiquement directement entre les raccords 7 et 8 à travers la couche 5.

Au besoin, on pourra aussi prévoir de telles lignes de séparation pour l'isolement électrique du raccord 6 par rapport à la couche 5, dans la région dans laquelle il recouvre la couche 5. Une exécution possible avec deux lignes de séparation de part et d'autre du raccord est indiquée en traits mixtes dans la figure.

La configuration illustrée ici de raccords et de pistes conductrices assure qu'en appliquant une tension continue aux raccords 7 et 8 et aux deux portions de pistes conductrices 7' et 8' orientées horizontalement (dans la représentation), il circule un courant réparti uniformément sur la surface de la couche conductrice 5. La couche 5 sert en l'occurrence d'électrode de masse de l'élément lumineux EL 2. Une des pistes conductrices 7' ou 8' forme le point de réception commun du courant sortant aussi bien pour l'élément lumineux EL 2 que pour le chauffage de la couche.

La résistance électrique de la couche (des résistances de surface usuelles de telles couches se situent entre 2 et 4 Ω/carré) conduit à un chauffage lors du passage de courant. La puissance de chauffage produite est utilisée pour le réglage ciblé de la température de l'élément lumineux EL 2. A cet effet, il est prévu une commande de température 10, qui détermine la température réelle de l'élément lumineux EL 2 avec (au moins) un capteur de température 11 (par exemple un élément PTC à poser à plat) directement dans ou sur la vitre feuilletée 1. Elle fait partie d'une commande centralisée 12, représentée seulement de façon schématique, qui est à son tour reliée à une alimentation électrique pour les courants de puissance et de mesure/commande et qui gère toutes les fonctions électriques de la vitre 1, en particulier aussi l'alimentation électrique de l'élément lumineux EL 2. S'il s'agit d'une vitre (de toit) à mouvement électrique dans un véhicule, la commande centralisée peut alors comprendre aussi la commande de sa position. La commande de température 10 comprend en tout cas les éléments de construction et de commutation, qui sont nécessaires pour le réglage d'une température de consigne dans la région du capteur de température 11. Elle appliquera en particulier automatiquement la tension d'alimentation nécessaire aux raccords 7 et 8, lorsque le capteur de température signale une température réelle inférieure à une valeur prédéterminée, et elle coupera la tension d'alimentation lorsqu'une température de consigne prédéterminée sera de nouveau atteinte.

Ceci peut le cas échéant se produire aussi lorsque le véhicule est à l'arrêt, lorsque l'on doit empêcher une transparence indésirable d'un élément de vitre avec une transmission de lumière à commande électrique.

Bien entendu, tout dommage thermique à l'élément lumineux EL 2 dû au chauffage est exclu par une limitation de la puissance de chauffage, respectivement de la température maximale réalisable. Même si le chauffage de la vitre 1 au moyen de la couche 5 doit pouvoir être enclenché d'une autre manière, en particulier manuellement, on peut alors empêcher tout chauffage supplémentaire à l'aide du capteur de température 11, lorsqu'un apport de chaleur supplémentaire dans une ambiance de toute façon chaude ferait craindre un dommage thermique à l'élément lumineux EL 2.

Enfin, la commande de température, respectivement la commande centralisée, peut être configurée de telle manière que l'élément lumineux EL 2 ne puisse être enclenché que lorsque la température se trouve à l'intérieur d'un domaine non préjudiciable pour son fonctionnement. Cela signifie que son fonctionnement pourrait être empêché, par exemple aussi en cas de températures ambiantes extrêmes.

## Revendications

1. Vitre feuilletée (1) comportant au moins une vitre rigide et un élément fonctionnel plat (2) à commande électrique tel qu'un élément lumineux électroluminescent, ainsi qu'au moins une mince couche électriquement conductrice (5), **caractérisée en ce que** l'élément fonctionnel plat (2) est un élément lumineux électroluminescent et **caractérisée en ce que** la couche (5) forme en même temps une électrode plate de l'élément fonctionnel (2), la couche (5) pouvant être alimentée avec une tension électrique et chauffée indépendamment de l'alimentation électrique de l'élément fonctionnel (2), la couche (5) étant mise en liaison électriquement conductrice avec au moins deux pistes conductrices (7', 8') destinées à fournir une tension d'alimentation pour le chauffage, qui sont disposées de part et d'autre de l'élément fonctionnel (2) recouvrant la couche.

2. Vitre feuilletée suivant la revendication 1, **caractérisée en ce que** la couche (5) est alimentée automatiquement avec la tension en fonction d'un signal de température d'un capteur de température (11) envoyé à une commande de température (10).

3. Vitre feuilletée suivant la revendication 2, **caractérisée en ce que** le capteur de température (11) est associé dans l'espace à l'élément fonctionnel (2) et détermine la température réelle de celui-ci.

4. Vitre feuilletée suivant l'une quelconque des revendications précédentes, **caractérisée en ce que** l'élément fonctionnel (2) recouvre au moins en partie la surface de la couche (5).

5. Vitre feuilletée suivant l'une quelconque des revendications précédentes, **caractérisée en ce que** l'élément fonctionnel (2) est monté directement sur la vitre rigide.

6. Vitre feuilletée suivant l'une quelconque des revendications 1 à 4, **caractérisée en ce que** l'élément fonctionnel (2) est monté sur un substrat porteur propre.

7. Vitre feuilletée suivant l'une quelconque des revendications précédentes, comportant au moins deux vitres rigides et une couche intermédiaire assemblant celles-ci l'une à l'autre, dans laquelle l'élément fonctionnel (2) et la couche électriquement conductrice (5) sont logés dans la couche intermédiaire ou sont disposés sur une face interne d'une des vitres rigides.

8. Vitre feuilletée suivant l'une quelconque des revendications précédentes, **caractérisée en ce qu'**il est prévu plusieurs éléments fonctionnels les uns à côté des autres, à enclencher indépendamment les uns des autres, qui comportent une électrode (de masse) commune.

9. Vitre feuilletée suivant l'une quelconque des revendications précédentes, **caractérisée en ce qu'**il est prévu au moins deux éléments lumineux électroluminescents l'un au-dessus de l'autre, à enclencher indépendamment l'un de l'autre, qui comportent une électrode centrale commune.

10. Vitre feuilletée suivant la revendication 9, **caractérisée en ce que** l'électrode centrale commune est la couche chauffante (5).

11. Procédé pour utiliser un élément fonctionnel plat (2) ayant des propriétés à commande électrique, associé à une vitre feuilletée (1), dans lequel la vitre feuilletée comprend au moins une vitre rigide et un élément fonctionnel plat (2) à commande électrique tel qu'un élément lumineux électroluminescent, ainsi qu'au moins une mince couche électriquement conductrice (5), **caractérisée en ce que** l'élément fonctionnel plat (2) est un élément lumineux électroluminescent et **caractérisée en ce que** la couche (5) forme en même temps une électrode plate de l'élément fonctionnel (2), la couche (5) est alimentée avec une tension électrique et chauffée indépendamment de l'alimentation électrique de l'élément fonctionnel (2), la couche (5) étant mise en liaison électriquement conductrice avec au moins deux pistes conductrices (7', 8') destinées à fournir une tension d'alimentation pour le chauffage, qui sont disposées de part et d'autre de l'élément fonctionnel (2) recouvrant la couche, lorsqu'une température réelle de l'élément fonctionnel plat (2) déterminée à l'aide d'un capteur de température (11) est inférieure à une température de consigne prédéterminée.

12. Procédé suivant la revendication 11, **caractérisé en ce que** l'alimentation électrique de l'élément fonctionnel plat (2) ne peut être enclenchée que si la température de consigne de celui-ci est réglée.

## Patentansprüche

1. Laminierte Scheibe (1), die wenigstens eine starre Scheibe und ein ebenes funktionales Element (2) mit elektrischer Steuerung wie etwa ein Elektromlumineszenz-Leuchtelement sowie wenigstens eine elektrisch leitende dünne Schicht (5) umfasst, **dadurch gekennzeichnet, dass** das ebene funktionale Element (2) ein Elektromlumineszenz-Leuchtelement ist, und **dadurch gekennzeichnet, dass** die Schicht (5) gleichzeitig eine ebene Elektrode des funktionalen Elements (2) bildet, wobei die Schicht (5) mit einer elektrischen Spannung versorgt werden kann und unabhängig von der elektrischen Versorgung des funktionalen Elements (2) erwärmt werden kann, wobei die Schicht (5) in elektrisch leitender Verbindung mit wenigstens zwei leitenden Bahnen (7', 8') ist, die dazu bestimmt sind, eine Versorgungsspannung für die Erwärmung bereitzustellen, und beiderseits des funktionalen Elements (2) angeordnet sind und die Schicht bedecken.

2. Laminierte Scheibe nach Anspruch 1, **dadurch gekennzeichnet, dass** die Schicht (5) als Funktion eines Temperatursignals eines Temperatursensors (11), das an eine Temperatursteuerung (10) geschickt wird, automatisch mit der Spannung versorgt wird.

3. Laminierte Scheibe nach Anspruch 2, **dadurch gekennzeichnet, dass** der Temperatursensor (11) dem funktionalen Element (2) räumlich zugeordnet ist und dessen Ist-Temperatur bestimmt.

4. Laminierte Scheibe nach einem der vorhergehenden Ansprüche, **dadurch gekennzeichnet, dass** das funktionale Element (2) wenigstens einen Teil der Oberfläche der Schicht (5) abdeckt.

5. Laminierte Scheibe nach einem der vorhergehenden Ansprüche, **dadurch gekennzeichnet, dass** das funktionale Element (2) direkt auf die starre Scheibe montiert ist.

6. Laminierte Scheibe nach einem der Ansprüche 1 bis 4, **dadurch gekennzeichnet, dass** das funktionale Element (2) auf ein eigenes Trägersubstrat montiert ist.

7. Laminierte Scheibe nach einem der vorhergehenden Ansprüche, die wenigstens zwei starre Scheiben und eine Zwischenschicht, die beide miteinander verbindet, umfasst, wobei das funktionale Element (2) und die elektrisch leitende Schicht (5) in der Zwischenschicht aufgenommen sind oder auf einer Innenfläche einer der starren Scheiben angeordnet sind.

8. Laminierte Scheibe nach einem der vorhergehenden Ansprüche, **dadurch gekennzeichnet, dass** mehrere funktionale Elemente nebeneinander vorgesehen sind und unabhängig voneinander einzuschalten sind und eine gemeinsame (Masse-)Elektrode enthalten.

9. Laminierte Scheibe nach einem der vorhergehenden Ansprüche, **dadurch gekennzeichnet, dass** wenigstens zwei Elektromlumineszenz-Leuchtelemente übereinander vorgesehen sind, die unabhängig voneinander einzuschalten sind und eine gemeinsame Mittelelektrode enthalten.

10. Laminierte Scheibe nach Anspruch 9, **dadurch gekennzeichnet, dass** die gemeinsame Mittelelektrode die Erwärmungsschicht (5) ist.

11. Verfahren für die Verwendung eines ebenen funktionalen Elements (2), das Eigenschaften einer elektrischen Steuerung besitzt und einer laminierten Scheibe (1) zugeordnet ist, wobei die laminierte Scheibe wenigstens eine starre Scheibe und ein ebenes funktionales Element (2) mit elektrischer Steuerung wie etwa ein Elektrolumineszenz-Leuchtelement und wenigstens eine elektrisch leitende dünne Schicht (5) umfasst, **dadurch gekennzeichnet, dass** das ebene funktionale Element (2) ein Elektrolumineszenz-Leuchtelement ist, und **dadurch gekennzeichnet, dass** die Schicht (5) gleichzeitig eine ebene Elektrode der funktionalen Schicht (2) bildet und die Schicht (5) mit einer elektrischen Spannung versorgt wird und unabhängig von der elektrischen Versorgung des funktionalen Elements (2) erwärmt wird, wobei die Schicht (5) in elektrisch leitender Verbindung mit wenigstens zwei leitenden Bahnen (7', 8') ist, die dazu bestimmt sind, eine Versorgungsspannung für die Erwärmung bereitzustellen, und die beiderseits des funktionalen Elements (2) angeordnet sind und die Schicht bedecken, wenn eine Ist-Temperatur des ebenen funktionalen Elements (2), die mit Hilfe eines Temperatursensors (11) bestimmt wird, kleiner als eine vorgegebene Soll-Temperatur ist.

12. Verfahren nach Anspruch 11, **dadurch gekennzeichnet, dass** die elektrische Versorgung des ebenen funktionalen Elements (2) nur dann eingeschaltet wird, wenn dessen Soll-Temperatur reguliert wird.

## Claims

1. Laminated panel assembly (1) comprising at least one rigid panel, an electrically controllable flat functional element (2), such as an electroluminescent lighting element, and at least one electrically conducting thin film (5), **characterized in that** the flat functional element (2) is an electroluminescent lighting element and **characterized in that** the film (5) forms at the same time a flat electrode of the functional element (2), the film (5) being able to be supplied with an electrical voltage and heated independently of the power supply for the functional element (2), the film (5) being in electrically conducting contact with at least two conducting tracks (7', 8') intended to deliver a supply voltage for the heating, which tracks are placed on either side of the functional element (2) covering the film.

2. Laminated panel assembly according to Claim 1, **characterized in that** the film (5) is supplied automatically with the voltage according to a temperature signal sent to a temperature control (10) from a temperature sensor (11).

3. Laminated panel assembly according to Claim 2, **characterized in that** the temperature sensor (11) is combined in the space with the functional element (2) and determines the actual temperature of the latter.

4. Laminated panel assembly according to any one of the preceding claims, **characterized in that** the functional element (2) covers at least part of the surface of the film (5).

5. Laminated panel assembly according to any one of the preceding claims, **characterized in that** the functional element (2) is mounted directly on the rigid panel.

6. Laminated panel assembly according to any one of Claims 1 to 4. **characterized in that** the functional element (2) is mounted on a specific supporting substrate.

7. Laminated panel assembly according to any one of the preceding claims, comprising at least two rigid panels and an interlayer joining them together, in which assembly the functional element (2) and the electrically conducting film (5) are housed within the interlayer or are placed on an internal face of one of the rigid panels.

8. Laminated panel assembly according to any one of the preceding claims, **characterized in that** several functional elements are provided, side by side, to be operated independently of one another, which include a common (ground) electrode.

9. Laminated panel assembly according to any one of the preceding claims. **characterized in that** at least two electroluminescent lighting elements are provided, one on top of another, to be operated independently of one another, which include a common central electrode.

10. Laminated panel assembly according to Claim 9, **characterized in that** the common central electrode is the heating film.

11. Method for using a flat functional element (2) having electrically controllable properties, combined with a laminated panel assembly (1), in which the laminated panel assembly comprises at least one rigid panel and an electrically controllable flat functional element (2), such as an electroluminescent lighting element, and at least one electrically conducting thin film (5), **characterized in that** the flat functional element (2) is an electroluminescent lighting element and **characterized in that** the film (5) forms at the same time a flat electrode of the functional element (2), the film (5) is supplied with an electrical voltage and heated independently of the power supply for the functional element (2), the film (5) being in electrically conducting contact with at least two conducting tracks (7', 8') intended to deliver a supply voltage for the heating, which tracks are placed on either side of the functional element (2) covering the film, when the actual temperature of the flat functional element (2), determined by means of a temperature sensor (11), is below a predetermined setpoint temperature.

12. Method according to Claim 11, **characterized in that** the power supply for the flat functional element (2) can be operated only if the setpoint temperature of the latter is set.
